Europäisches Patentamt

European Patent Office

Office européen des brevets

(11) Numéro de publication: **0 199 256 B1**

# FASCICULE DE BREVET EUROPEEN

(45) Date de publication de fascicule du brevet:
**21.11.91**

(51) Int. Cl.⁵: **G01R 31/00**

(21) Numéro de dépôt: **86105163.9**

(22) Date de dépôt: **15.04.86**

(54) **Dispositif de suivi pour transformateur de distribution d'énergie électrique.**

(30) Priorité: **17.04.85 FR 8505796**

(43) Date de publication de la demande:
**29.10.86 Bulletin 86/44**

(45) Mention de la délivrance du brevet:
**21.11.91 Bulletin 91/47**

(84) Etats contractants désignés:
**AT BE CH DE FR GB IT LI LU NL SE**

(56) Documents cités:
**FR-A- 2 462 714**
**FR-A- 2 538 558**
**US-A- 3 846 698**

(73) Titulaire: **GEC ALSTHOM SA**
**38, avenue Kléber**
**F-75116 Paris(FR)**

(72) Inventeur: **Aftalion, René**
**12 Allée des Hauts Dimanches**
**F-78430 Louveciennes(FR)**

(74) Mandataire: **Weinmiller, Jürgen et al**
**Lennéstrasse 9 Postfach 24**
**W-8133 Feldafing(DE)**

Rank Xerox (UK) Business Services

## Description

La présente invention a pour objet un dispositif de suivi pour transformateur de distribution d'énergie électrique.

Il est connu de superviser, au moyen d'un agencement comportant au moins un microprocesseur, des mémoires et une horloge, une distribution d'énergie effectuée à partir d'un transformateur.

Le document FR-A-2538 558 décrit ainsi un dispositif de détection et de diagnostic des défauts électriques sur alimentation, dans lequel un agencement tel qu'évoqué ci-dessus est relié aux bornes d'un transformateur de distribution par des organes de mesure et via une interface de saisie, une seconde interface permettant de relier l'agencement à une unité de gestion extérieure.

Toutefois, les conditions réelles de fonctionnement des transformateurs de distribution d'énergie en exploitation sont généralement mal connues, car si l'on dispose bien d'instruments permettant d'effectuer des mesures, par exemple pour déterminer les courants électriques délivrés pour chaque phase ou la température atteinte à un organe dénommé doigt de gant, lorsqu'il existe, il n'y a généralement pas de moyens prévus pour enregistrer systématiquement les mesures faites de manière à connaître le vieillissement réel d'un transformateur de distribution installé, puisqu'il n'y a pratiquement pas d'information directes permettant de connaître la manière dont il est réellement exploité au cours du temps.

En conséquence, il se produit des avaries, par exemple des claquages, qui pourraient être évitées, si les conditions réelles de fonctionnement étaient mieux connues et si l'évolution dans le temps de ces conditions avait été suivie.

De plus lorsque la charge d'un transformateur augmente au cours du temps, avec les besoins croissants des utilisateurs, il arrive un moment où le coût des pertes par effet Joule est tel que le remplacement de ce transformateur par un transformateur de taille supérieure est à envisager. Or rien jusqu'ici n'est prévu pour fournir des données sur cette évolution et pour permettre la prise d'une décision sur des informations précises.

La présente invention propose donc un dispositif de suivi pour transformateur de distribution d'énergie électrique permettant de remédier aux inconvénients évoqués ci-dessus et plus particulièrement de déterminer si la puissance électrique assignée est et reste adaptée à l'utilisation réelle, de mémoriser les anomalies d'exploitation et de fournir une indication sur l'état de vieillissement du transformateur à partir des mesures faites au fur et à mesure de son utilisation, ce dispositif de suivi visant à être simple, fiable et peu coûteux.

Le dispositif de suivi selon l'invention est préférablement destiné à un transformateur de distribution d'énergie électrique auquel on ajoute des organes de mesure, notamment d'intensité et de température, aptes à communiquer, usuellement par voie électrique, les résultats des mesures qu'ils effectuent.

Selon une caractéristique de l'invention, le dispositif de suivi comporte un agencement, installé sur le site du transformateur suivi et composé selon un arrangement connu, d'un microprocesseur, associé à des mémoires et doté d'une horloge interne ou externe, d'une alimentation secourue pour le microprocesseur, l'horloge et les mémoires et de deux interface de raccordement, l'une aux organes du transformateur, l'autre à une unité de gestion extérieure, via éventuellement un équipement de saisie informatique portable, pour collecter les résultats fournis par les organes de mesure associés au transformateur et pour les restituer à la demande, après traitement, l'agencement selon l'invention comporte de moyens de suivi de température aptes à comptabiliser les durées de fonctionnement du transformateur à l'intérieur de gammes prédéterminées de température de point chaud à partir des relevés de température cycliquement effectués par l'intermédiaire d'au moins un organe de mesure affecté au transformateur, des moyens de suivi de la charge du transformateur aptes à comptabiliser les durées de fonctionnement du transformateur à l'intérieur de gammes prédéterminées d'intensités à partir de relevés d'intensité cycliquement effectués par l'intermédiaire d'au moins un organe de mesure d'intensité pour chaque phase secondaire du transformateur, des moyens de suivi des pertes du transformateur définissant lesdites pertes à partir des relevés de température et d'intensité effectués et des moyens de détermination de vieillissement fournissant au moins un indice de vieillissement pour le transformateur en fonction des indications comptabilisées par les divers moyens de suivi.

L'invention, ses caractéristiques et ses avantages sont précisés dans la description qui suit en liaison avec les figures répertoriées ci-dessous.

La figure 1 présente un schéma d'un dispositif de suivi selon l'invention.

Les figures 2A, 2B présentent un exemple de réalisation du dispositif selon l'invention.

La figure 3 présente un représentation symbolique schématisant le programme de suivi.

La figure 4 présente un représentation symbolique schématisant le programme de datation.

La figure 5 présente un représentation symbolique schématisant le programme de mesure et traitement.

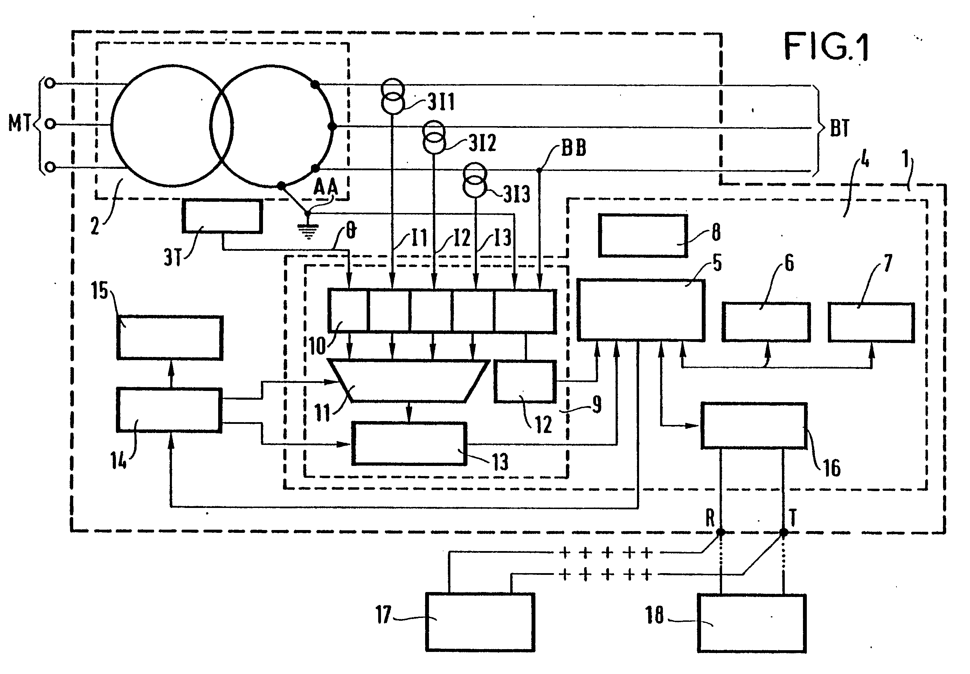

Le dispositif de suivi pour transformateur de distribution d'énergie qui est présenté figure 1 est destiné à être installé sur un site 1 où se trouve installé un transformateur de distribution 2 que l'on désire surveiller. Ce transformateur de distribution 2, classiquement alimenté en triphasé moyenne tension par l'intermédiaire d'une liaison MT, est destiné à alimenter en énergie électrique basse tension des utilisateurs raccordés aux bornes des enroulements secondaires du transformateur par la liaison BT selon des techniques de répartition connues et non figurées, les utilisateurs alimentés en monophasé étant répartis sur les différentes phases selon une disposition estimée équilibrée lors du raccordement.

Le transformateur de distribution 2 est muni d'organes de mesure 3 permettant de relever différents paramètres relatifs à son fonctionnement. Dans l'exemple présenté ces organes de mesure comprennent au moins un capteur de température 3T associé au transformateur et au moins trois capteurs d'intensité 3I1, 3I2, 3I3 respectivement affecté chacun à la mesure du courant produit par l'un des trois enroulements secondaires. Ces capteurs d'intensité et de température peuvent être montés sur des transformateurs déjà installés et exploités.

Le capteur de température de type sonde thermométrique classique est disposé sur le transformateur de manière à fournir une indication réaliste concernant l'échauffement de ce transformateur. Il n'est généralement pas possible de placer cette sonde thermométrique au point le plus chaud du transformateur, comme il serait souhaitable, dans la mesure où la localisation de ce point le plus chaud est délicate puisque son emplacement est susceptible de varier en fonction des conditions d'exploitation pour des transformateurs de constitution identique. Par contre les constructeurs savent déterminer la zone où une sonde thermomètrique peut être placé pour fournir des indications significatives pour un type de transformateur donné et pour permettre de calculer la température d'un point chaud théorique. Ainsi par exemple, la publication 354, de la Commission Electrotechnique Internationale sur les transformateurs immergés dans l'huile permet de déterminer la température de point chaud d'un transformateur connaissant notamment sa charge et la température d'un point par exemple en haut de cuve.

Les capteurs d'intensité 3I sont classiquement du type pince ampèremètrique et ils sont placés autour des bornes des enroulements secondaires du transformateur ou des câbles basse-tension de la liaison BT qui sont connectés à ces bornes.

Une détection de la présence de tension aux bornes du secondaire du transformateur est ici assurée au niveau de deux bornes AA et BB qui permettent dans l'exemple présenté de contrôler la présence de tensions au secondaire du transformateur par détermination de la tension effectivement présente entre l'une des phases, ici la troisième pour la borne BB et le neutre ou la masse pour la borne AA.

Un agencement 4, préférablement logé dans un contenant électriquement blindé, vient se connecter aux bornes AA, BB et aux organes de mesure 3 pour permettre de collecter les informations obtenues en vue de les restituer à la demande après un traitement visant à les condenser et à les présenter sous forme significative en vue de leur exploitation au profit de l'exploitant producteur d'énergie ou consommateur, par une unité de gestion, normalement située à distance.

L'agencement 4 est organisé autour d'un micro-ordinateur incluant classiquement un microprocesseur 5 associé à des mémoires 6 et 7 l'une vive, l'autre morte et doté d'une horloge 8 permettant la fourniture d'indications relatives au temps réel. Cette horloge 8 figurée ici extérieurement au microprocesseur 5 peut alternativement y être incorporée, elle assure classiquement par des liaisons usuelles non représentées une fonction de synchronisation des opérations effectuées par les différents élements constituant l'agencement 4, en plus de la fonction de calendrier évoqué ci-dessus au niveau de la fourniture des indications de temps réel.

Le microprocesseur 5 est relié aux organes de mesure 3 et aux bornes AA, BB par l'intermédiaire d'une interface de raccordement 9 chargée de la mise en forme numérique des mesures effectuées classiquement fournies sous forme analogique, ainsi que de la protection des circuits logiques très basse tension de l'interface vis à vis des basses tensions présentes au secondaire du transformateur.

En ce but l'interface de raccordement 9 comporte un ensemble 10 de circuits de protection et de mise en forme individuels reliant par exemple les circuits logiques aux bornes A, B et aux organes de mesure 3 par l'intermédiaire de transformateurs d'isolements. Dans l'exemple présenté les circuits logiques de l'interface comprennent un multiplexeur 11, un détecteur de tension 12 et un convertisseur analogique-numérique 13.

Le multiplexeur 11 est relié par ses entrées aux organes de mesure 3, via les circuits de protection individuels correspondants de l'ensemble 10, et par sa sortie à l'entrée du convertisseur analogique-numérique 13, le détecteur de tension 12 est également relié aux bornes AA et BB, via un circuit de protection individuel dudit ensemble 10.

Le détecteur de tension 12 et le convertisseur 13 ont individuellement accès à des entrées du microprocesseur 5 d'une manière qui est précisée plus loin, le microprocesseur 5 assure, en liaison avec l'horloge 8, la commande du multiplexeur 11 et du convertisseur 13, via un circuit d'actionnement 14 qui contrôle également une unité de signalisation 15 permettant de transmettre localement et éventuellement à distance un certain nombre d'informations relatives au fonctionnement, de manière visuelle et/ou sonore.

Cette unité de signalisation 15 permettant par exemple de savoir si l'agencement 1 est en service, de déclencher une alarme, de permettre la visualisation des étapes caractéristiques des opérations de mise en service, etc ...

Le microprocesseur 5 est également relié à une interface de transmission 16 destinée à permettre le transfert des informations condensées et traitées vers une unité de gestion distante 17.

Cette interface de transmission 16 permet par exemple l'établissement d'une liaison asynchrone bidirectionnelle de type RS 232C entre le microprocesseur 5 et l'unité de gestion 17 distante par voie directe, soit encore indirectement par l'intermédiaire d'une unité de saisie 18 portable sucessivement connectable à l'interface de transmission 16, puis à l'unité de gestion 17.

L'unité de saisie 18 comporte par exemple un microprocesseur usuel associé à une mémoire de masse, un clavier et un écran de visualisation non figurés, elle peut notamment être constituée par un petit microordinateur portable du commerce.

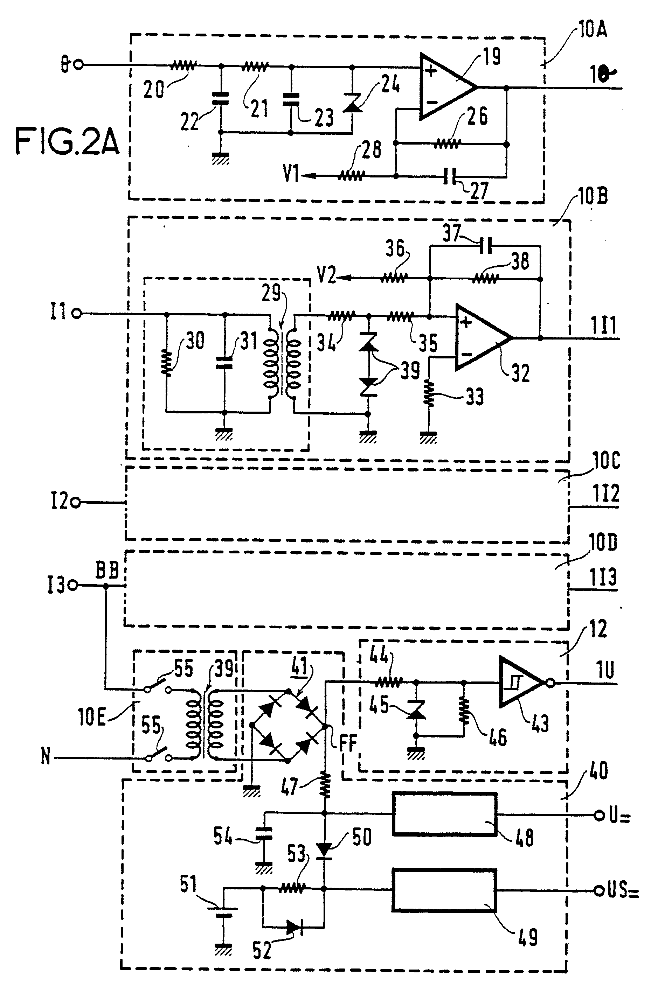

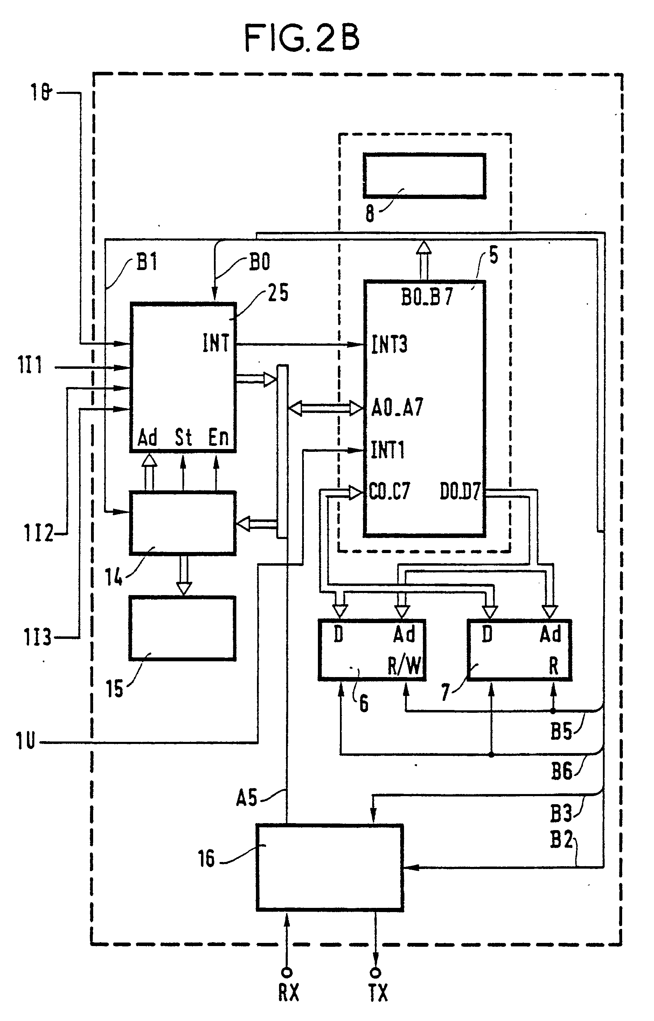

Les figures 2A, 2B permettent de préciser la constitution de l'agencement 4 et notamment des circuits de protection et de mise en forme individuels de l'ensemble 10.

Le capteur de température 3T fournit ses indications de température par l'intermédiaire d'une liaison θ à un circuit de protection et de mise en forme 10A sous la forme d'une tension continue appliquée à l'entrée non-inverseuse d'un amplificateur opérationnel 19 via un filtre composé de deux cellules RC constituées à l'aide de deux résistances 20, 21 en série associées à deux capacités 22,23 insérées l'une entre la masse et le point commun entre les deux résistances 20,21 et l'autre entre la masse et l'entrée non-inverseuse de l'amplificateur opérationnel 19 ; cette entrée non-inverseuse située en sortie de filtre est également reliée à la masse via une diode Zener d'écrètage 24, la sortie 1θ de l'amplicateur opérationnel 19 est reliée à une première entrée du multiplexeur 11, qui dans l'exemple choisi, est associé au convertisseur analogique-digital dans un même circuit monolithique 25, tel un circuit ADC0808 fabriqué par National Semiconductor.

Classiquement la sortie 1θ et l'entrée inverseuse de l'amplificateur opérationnel 19 sont reliées par un montage de contre-réaction 26, 27, 28, ce montage comprend une résistance 26 et une capacité 27 en parallèle, ladite entrée inverseuse étant également reliée à un potentiel prédéterminé V1, via une résistance 28.

Chacun des capteurs d'intensité 3I1, 3I2, 3I3, fournit ses indications au circuit de protection et de mise en forme 10B, 10C ou 10D correspondant sous forme d'une tension prise entre la masse et un fil I1, I2 ou I3 et appliquée aux bornes du primaire d'un transformateur monophasé d'isolement, tel le transformateur d'isolement 29 pour la phase 1 dont la tension mesurée entre le fil I1 et la masse, est appliquée en parallèle aux bornes d'une résistance 30, d'une capacité 31 et de l'enroulement primaire du transformateur 29, selon un montage commun.

L'enroulement secondaire du transformateur 29 attaque un amplificateur opérationnel 32 dont l'entrée non-inverseuse est reliée au potentiel de masse, via une résistance 33, de même que l'une des extrémités dudit enroulement secondaire, alors que l'entrée inverseuse dudit amplificateur opérationnel 32 est relié à l'autre extrémité d'enroulement secondaire via deux résistances 34, 35 en série, deux diodes Zener en opposition étant insérées entre la masse et le point commun aux résistances 34, 35 et un montage de contre-réaction et de polarisation 36, 37, 38 analogue au montage 26, 27, 28 étant connecté entre sortie et entrée inverseuse de l'amplificateur opérationnel 32. La sortie référencée 1I1 de l'amplificateur opérationnel 32 qui constitue la sortie du circuit de protection et de mise en forme 10B est reliée à une seconde entrée du multiplexeur du circuit monolithique 25 dont les autres entrées de données sont ici respectivement reliées aux sorties des circuits de protection et de mise en forme 10C, 10D constitués comme le circuit 10B et associés comme lui chacun à une phase secondaire du transformateur 2.

Les bornes A, B sont reliées au circuit de protection 10E qui comporte essentiellement un commutateur de mise sous tension 55 et un transformateur d'isolement 39 chargé ici d'alimenter d'une part le détecteur de tension 12, d'autre part une alimentation secourue 40 de l'agencement 4, via un pont redresseur à diodes 41. La tension redressée fournie par le pont est appliquée au détecteur de tension 12 réalisé à l'aide d'une bascule de Schmitt inverseuse 43 dont l'entrée est d'une part reliée à la borne positive FF du pont 41, via une résistance 44, et d'autre part reliée à la masse, via une diode Zener 45 et une résistance 46 en parallèle. L'alimentation secourue 40 a pour objet d'alimenter les divers éléments composant l'agencement 4, elle est normalement alimentée par le pont redresseur 41, via une résistance de limitation 47 et elle fournit par l'intermédiaire d'un premier régulateur 48 classique l'énergie nécessaire aux différents éléments de l'agencement 4 à l'exception de ceux, constitués par le microprocesseur 5, son horloge 8 interne ou externe et ses mémoires, qui sont alimentés via un second régulateur 49 également classique. Le second régulateur 49 est normalement alimenté par le pont redresseur via la borne FF, la résistance 47 et une diode 50. Une source d'énergie d'appoint 51, de type pile ou batterie, alimente le second régulateur 49 de manière à permettre une sauvegarde de données essentielles et le maintien en fonctionnement de l'horloge en l'absence de tension au point FF par suite d'une coupure de l'alimentation fournie par le secondaire du transformateur au transformateur d'isolement 39, ici entre phase 3 via le fil I3 et neutre via le fil N.

La source d'appoint 51 est reliée à l'entrée du second régulateur 49, via un ensemble diode 52 résistance 53 en parallèle, qui est connecté à la cathode de la diode 50, cette diode étant connectée au premier régulateur 48 et à une capacité 54 dont l'autre borne est à la masse.

Le circuit monolithique 25, défini plus haut, est apte à transmettre au microprocesseur 5 sous forme numérique les signaux qu'il reçoit sous forme analogique via les liaisons 1θ, 1I1, 1I2, 1I3. En ce but il est relié par sa sortie de données aux entrées/sorties de données A0-A7 d'un port A bidirectionnel du microprocesseur 5 qui est par exemple un microprocesseur multiport TMS 7001 fabriqué par la société TEXAS INSTRUMENTS. Ce microprocesseur 5 commande cycliquement l'activation d'une des entrées du circuit monolithique 25 via le circuit d'actionnement 14, de type classique, qui fournit l'adresse Ad de l'entrée à activer, une commande de démarrage St et une autorisation En qu'il reçoit lui-même du microprocesseur 5, via le port A lorsqu'il est activé par une sortie B1 d'un port unidirectionnel B.

Le circuit monolithique 25 fournit au microprocesseur 5, via le port A et sous forme d'un octet, la valeur du signal analogique appliqué à celle de ses entrées 1θ, 1I1, 1I2, 1I3 qui est sélectionnée. Le circuit monolithique 25 indique que la conversion est effectuée par une demande d'interruption INT appliquée à l'une des entrées d'interruption, telle INT3 du microprocesseur 5, celui-ci donnant alors l'autorisation de transfert via la sortie BO de son port B.

Le circuit détecteur de tension 12 attaque également une entrée d'interruption, telle INT1 du microprocesseur 5, via sa sortie 1U afin de déclencher la sauvegarde de données essentielles en mémoire et le comptage de temps de coupure.

De manière habituelle la mémoire vive 6 et la mémoire 7 communiquent avec le microprocesseur 5 pour les échanges de données D, via les entrées/sorties CO, C7 d'un port bidirectionnel C de ce microprocesseur et sont adressées, via les sorties DO-D7 d'un port bidirectionnel D, les sorties B5 et B6 du port B permettant respectivement l'écriture-lecture en mémoire via les entrées R/W et R correspondantes de la mémoire vive et de la mémoire morte et la sélection de la mémoire concernée.

Comme indiqué plus haut le microprocesseur 5 permet également le déclenchement de signalisations locales appropriées par exemple visuelles et/ou sonores, par l'intermédiaire de l'unité de signalisation 15 et via le circuit d'actionnement 14 sélectionné par une liaison émanant de la sortie B1 du port B et adressé via le port A. L'interface de transmission 16 est apte à émettre en asynchrone vers l'extérieur sur une liaison TX les données numériques qu'elle reçoit de la mémoire vive 6 via la sortie B3 du port B du microprocesseur 5, elle est également apte à recevoir des données en asynchrone d'une liaison RX à destination du microprocesseur 5 et de sa mémoire vive, via une entrée A5 du port A.

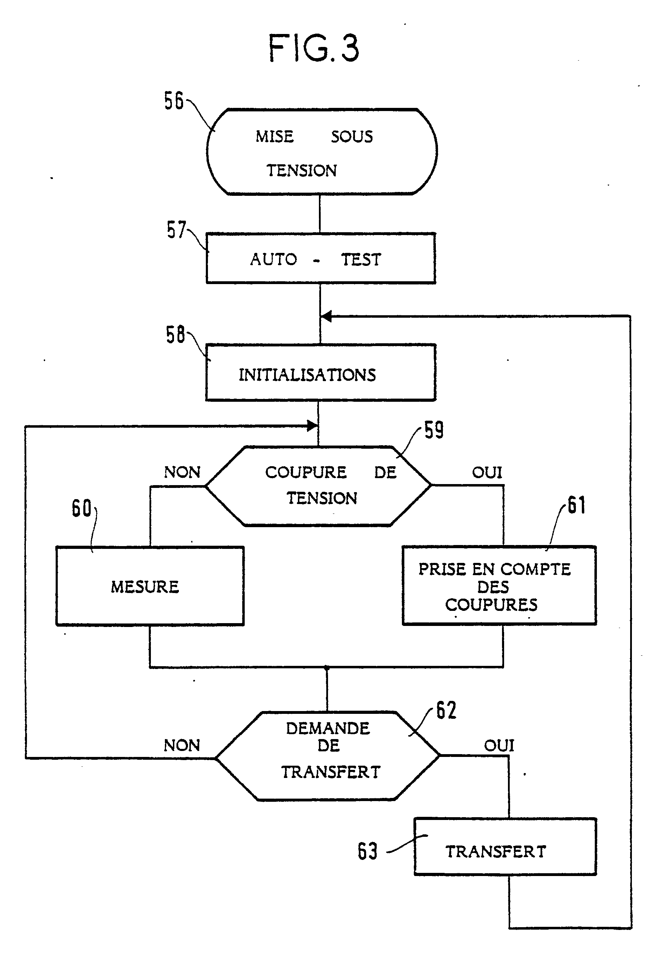

Le dispositif de suivi selon l'invention est programmé de manière à permettre la succession des opérations résumées en figure 3.

Le programme général démarre après mise sous tension du dispositif de suivi comme symbolisé par le pavé 56 et commence classiquement par un premier programme de test 57 du dispositif qui ne sera pas développé ici dans la mesure où il n'a qu'un rapport indirect avec l'invention.

Après déroulement satisfaisant de ce programme de test, le dispositif de suivi est soumis à un programme d'initialisation symbolisé par le pavé 58 qui permet notamment la mise à l'heure de l'horloge 8 par rapport au système horaire en vigueur pour le site où se trouve le transformateur, ainsi que l'introduction de données spécifiques d'exploitation liées au temps, au transformateur et/ou aux conditions d'exploitation du transformateur.

Après exécution du programme d'initialisation, l'horloge 8 assure la fourniture permanente des signaux nécessaires à l'accomplissement cyclique des mesures et à leur traitement ainsi qu'à la comptabilisation des coupures d'alimentation, elle est alimentée par l'alimentation secourue 40 de manière à fonctionner sans interruption.

Dans une forme de réalisation elle intervient également dans le déroulement d'un programme annexe de datation.

Ce programme de datation implique la mise à jour permanente d'un calendrier en raison des contraintes imposées par les caractéristiques horaires et tarifaires liées à l'exploitation du transformateur 2.

La partie essentielle du programme est composée d'un sous-programme 60 de mesure et d'un sous-programme 61 de prise en compte des coupures, ces sous-programmes 60 et 61 sont mutuellement exclusifs, le sous-programme 61 est mis en oeuvre dès disparition de la tension au secondaire du transformateur 2, c'est-à-dire dès coupure et il se poursuit pendant toute la durée de chaque coupure jusqu'à prise en compte de cette coupure à la réapparition de la tension au secondaire. En cas de disparition de tension, une interruption vient interrompre le sous-programme de mesure 60 normalement en cours à cet instant et lance le sous-programme de coupure 61. Le sous-programme 61 assure notamment la mesure de la durée de chaque coupure et la comptabilisation des coupures, par exemple en fonction de leurs durées. Le sous-programme 60 de mesures assure le déroulement et le traitement des mesures en vue de leur exploitation et en particulier de la comptabilisation des résultats afin d'obtenir les données qui seront conservées.

L'ensemble des données à conserver qui sont fournies par les sous-programmes 60 et 61 est mémorisé et sauvegardé afin d'être transféré à la demande de l'exploitant comme indiqué plus haut. Le transfert s'effectue par mise en oeuvre d'un sous-programme de transfert 63 et via l'interface de transmission 16, il est déclenché à la demande de l'exploitant et se traduit donc par la présence d'une demande de transfert, qui conditionnne le lancement de ce sous-programme comme le symbolise le point de décision 62.

En l'absence de demande de transfert le sous-programme 60 ou 61 en cours se répète tant qu'aucun changement n'intervient au niveau du point de décision 59.

Dans un exemple de réalisation, le dispositif de suivi est prévu pour fonctionner en autonome pendant une période d'observation de deux ans ; l'exécution du programme de transfert 61 a lieu au bout de ces deux ans et il est classiquement suivi d'un nouvelle mise en oeuvre du programme d'initialisation 58 permettant un nouveau fonctionnement autonome du dispositif de suivi pour deux ans.

Les programmes d'initialisation 58 et de transfert 61 sont de structure classique et ne seront donc pas décrits plus avant.

Comme on l'a vu, il est important de disposer de moyens de suivi des coupures d'énergie en ligne pour comptabiliser tant leur nombre que leurs durées au cours d'une période d'observation en vue d'assurer le suivi du transformateur 2. Dans la forme de réalisation choisie, les coupures sont détectées par surveillance quasi-permanente de la tension présente entre une phase et le neutre au secondaire du transformateur 2 au moyen du détecteur de tension 12.

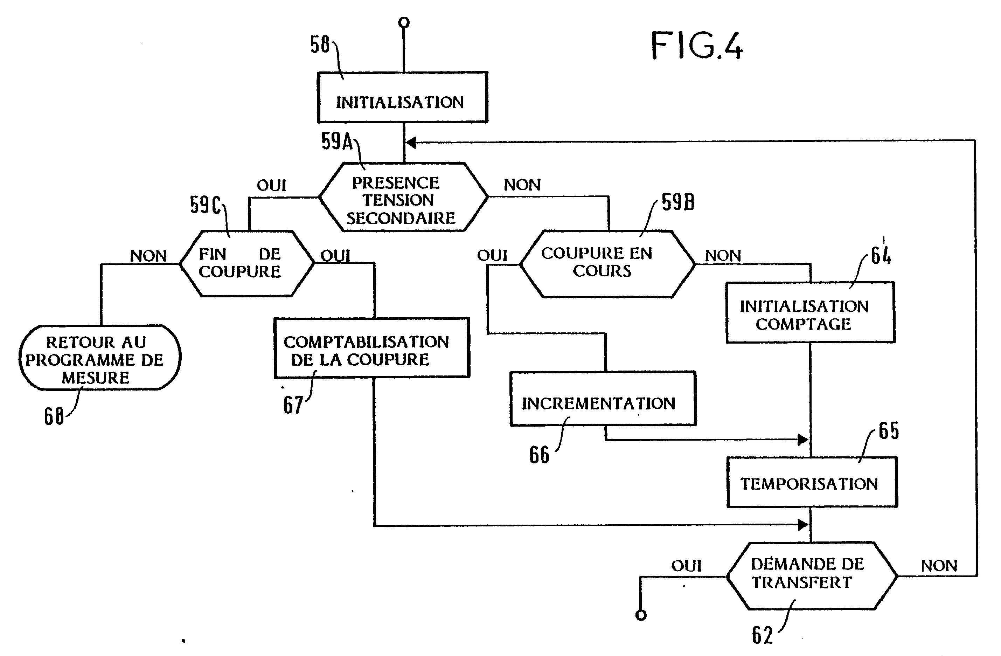

La figure 4 permet de préciser la structure du sous-programme 61 de prise en compte des coupures.

Pratiquement les décisions à prendre au niveau du point de décision 59 sont ici scindées en trois comme le symbolisent les points de décision 69A, 59B, 59C.

Le premier critère est pris en compte au niveau du point de décision 59A, il concerne la présence ou l'absence de tension au secondaire du transformateur 2. En l'absence de tension, un second critère est pris en compte au niveau du point de décision 59B en vue de déterminer si la coupure constatée est nouvelle ou non. Lorsque la coupure en course est nouvelle, un comptage de durée de coupure est initié, comme l'indique le pavé 64 et après une temporisation donnée, qui est indiquée par le pavé 65, le contrôle de présence de tension secondaire est à nouveau assurer au niveau du point de décision 59A, si aucun transfert n'a été demandé entre temps.

Lorsque la coupure constatée n'est pas nouvelle le comptage de durée de coupure est incrémenté comme l'indique le pavé 66 et le contrôle de présence de tension est également assuré au niveau du point de décision 59A après la temporisation donnée symbolisée par le pavé 65 et si aucune demande de transfert n'est en cours.

En présence de tension au secondaire, un troisième critère de tension est pris en compte au niveau du point de décision 59C pour déterminer si la présence de tension correspond à un retour en fin de coupure ou non.

Si la présence de tension fait suite à une préalable absence de tension, un programme modulaire 67 de comptabilisation de coupure est entrepris. Au cas contraire lorsque la tension est établi de manière stable il y a retour au programme de mesures 60, comme le symbolise le pavé 68.

Comme indiqué plus haut, le dispositif de suivi comporte des moyens de suivi des coupures aptes à comptabiliser la durée des coupures à l'intérieur de gammes prédéterminées de durée et leurs nombres à partir des indications d'absence de tension fournies par le circuit détection de tension 12.

La durée de chaque coupure est définie par rapport à l'horloge 8 ; l'instant de coupure et l'instant de rétablissement de la tension, qui le suit, sont respectivement pris en compte au niveau du programme 64 d'initialisation de comptage via les points de décision 59A et 59B et par le programme correspondant de prise en compte de coupure 67, via les points de décision 59A et 59C.

Dans une forme de réalisation les coupures sont classées en différentes catégories en fonction de leur durée, pour differencier notamment les microcoupures, des coupures plus longues et parmi celles-ci celles de trés longue durée, par exemple supérieures à deux heures.

Dans le but de limiter le volume de mémoire nécessaire, dans une forme préférée de réalisation chaque coupure se traduit donc par l'incrémentation d'un compteur d'une unité par coupure, l'ensemble des coupures relevées au cours du temps étant mémorisé par cumul sous forme matricielle usuelle. Ceci permet de déterminer le nombre de coupures intervenu dans chacune des plages prédéterminées de durée lors du relevé après une période d'observation.

Le programme de mesure 60 permet d'assurer le suivi en température et charge du transformateur 2 et la détermination de ses pertes et de son vieillissement.

Le dispositif du suivi comporte en conséquence des moyens de suivi en température aptes à comptabiliser les durées de fonctionnement du transformateur 2 à l'intérieur de gammes prédéterminées de température, à partir des relevés de température effectués par l'intermédiaire du capteur de température 3T. De même il comporte des moyens de suivi de la charge du transformateur 2 aptes à comptabiliser les durées de fonctionnement du transformateur à l'intérieur de gammes prédéterminées d'intensité à partir de relevés effectués par l'intermédiaire d'au moins un organe de mesure d'intensité pour chaque phase secondaire du transformateur 2.

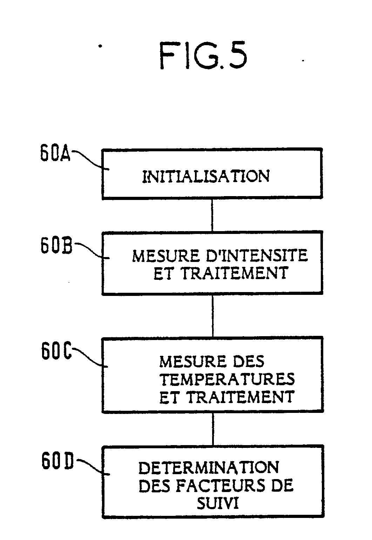

Le programme de mesure et traitement 60 présenté figure 5 commence par un sous-programme d'initialisation 60A de type usuel qui est lancé en l'absence de cycle de mesure en cours, suite à une coupure ou à une réinitialisation du dispositif de suivi.

Ce programme de mesure 60 comporte essentiellement un sous-programme de mesure et traitement des intensités 60B, un sous-programme de mesure et traitement des températures 60C et un sous-programme de détermination de facteurs 60D nécessaires au suivi du transformateur à partir des deux précédents, ce sous-programme 60D permet notamment la détermination des pertes et du vieillissement en fonction des deux facteurs plus particulièrement pris en compte ici. Le sous-programme de mesure et traitement des intensités 60B permet de déterminer et comptabiliser cycliquement une valeur d'intensité à sauvegarder pour chacune des phases secondaires du transformateur 2, il comporte en ce but des moyens de détermination de valeur à sauvegarder et des moyens de comptabilisation. Une succession de relevés de mesure est effectuée sur chacun des organes de mesures 3I1, 3I2, 3I3 en vue d'obtenir une valeur dite à sauvegarder par phase par l'intermédiaire d'un sous-programme de sauvegarde 60B1 du programme 60B.

Dans un exemple de réalisation, le programme 60B1 entraîne la réalisation de cycles de s relevés successifs de mesure d'intensité et la détermination des valeurs efficaces correspondantes pour chacune des m phases secondaires du transformateur 2. Les relevés s'effectuent par exemple au rythme d'un relevé toutes les cent microsecondes et de dix relevés successifs pour chaque phase et par cycle.

Le sous-programme 60B1 assure la détermination de la plus grande valeur d'intensité efficace obtenue à partir d'un groupe r.s valeurs efficaces successives d'intensité par phase.

La valeur d'intensité qui est prise en compte pour chaque phase du transformateur est obtenue à partir d'un calcul de valeur finale prenant la moyenne de n valeurs obtenues chacune en faisant la moyenne parmi p plus grandes valeurs efficaces successives pour la phase considérée, ce qui conduit par exemple à la détermination d'une valeur efficace à sauvegarder toutes les dix secondes.

La prise en compte des valeurs efficace d'intensité à sauvegarder, qui ont été produites par mise en oeuvre du sous-programme 60B1, est assurée par un programme 60B2 qui assure la comptabilisation de ces valeurs et éventuellement le déclenchement d'une alarme via l'unité de signalisation 15, par exemple en cas de surintensité exceptionnelle dangereuse.

La comptabilisation, s'effectue à l'intérieur de gammes d'intensité délimitées par des valeurs typiques d'intensité convenablement choisies en fonction des caractéristiques du transformateur 2. Dans un exemple de réalisation ces valeurs typiques, au nombre de quatre, délimitant cinq gammes et sont enregistrées dans les mémoires du microordinateur et qui sont donc éventuellement modifiables en cas de besoin.

Chaque valeur d'intensité efficace, dite à sauvegarder, incrémente un compteur sommateur correspondant à la gamme dans laquelle elle se situe et ce sont donc les valeurs atteintes par ces compteurs qui sont transmises lors des transferts de fin de période d'observation.

De manière analogue adaptée au fait que la température d'un transformateur n'est pas susceptible de varier aussi instantanément que les intensités qui parcourent ses enroulements secondaires, les mesures de température sont effectuées cycliquement et un calcul de valeur moyenne est effectuée tous les k relevés successifs.

Les moyens de suivi de température comportent donc eux aussi des moyens de détermination de valeur dite à sauvegarder et des moyens de comptabilisation.

La détermination des valeurs à sauvegarder s'effectue par l'intermédiaire d'un sous-programme de détermination du programme de mesure et traitement des températures 60C.

Ce sous-programme assure par exemple la réalisation d'un cycle de k = 18 relevés de température espacés toutes les dix secondes et le calcul d'une valeur moyenne, de température, à partir de laquelle est déterminée une température de point chaud destinée à être sauvegardée. Cette valeur moyenne de température est obtenue à partir de chaque série de k relevés successifs, chaque relevé n'étant pris en compte qu'une seul fois. Un sous-programme de prise en compte de température, qui fait suite au sous-programme évoqué ci-dessus dans le programme 60C, permet de comptabiliser les valeurs de température de point chaud qui sont sauvegardées, et éventuellement de déclencher une alarme comme celle prévue pour les intensités.

Comme précédemment la comptabilisation s'effectue à l'intérieur de gammes de température délimitées par des valeurs typiques convenablement choisies, qui sont enregistrées en mémoire du microordinateur.

Dans l'exemple de réalisation présenté le nombre de gammes de température est également de cinq et ces gammes sont limitées par quatre valeurs typiques réparties sur la plage de température de fonctionnement du transformateur 2. Ceci permet de comptabiliser de manière globale d'une part toutes les températures inférieures à la valeur typique minimale, située légèrement sous la température normale de fonctionnement, et d'autre part toutes les températures supérieures à une température voisine de la température maximale admise qui constitue la valeur typique maximale.

Chaque valeur de température à sauvegarder sert à incrémenter un compteur sommateur correspondant à la gamme de température où elle se situe et comme précédemment ce sont les valeurs atteintes par les différents compteurs qui sont transmises lors des transferts de fin d'observation.

Le programme de détermination des pertes et du vieillissement 60D utilise les valeurs de température et d'intensités sauvegardées pour déterminer d'une part ces pertes d'autre part un indice de vieillissement en vue de leur comptabilisation.

La détermination des pertes s'effectue cycliquement par calcul à partir des valeurs simultanément sauvegardées d'intensité et de température, ce calcul n'est pas détaillé ici dans la mesure où il s'effectue de manière classique par un programme sans originalité particulière.

Le cumul des pertes calculées au cours d'une période d'observation s'effectue là encore par l'intermédiaire d'au moins un compteur sommateur. Dans une forme de réalisation il est possible de tenir compte des différences de tarifs horaires en affectant un compteur par tarif comme pour les compteurs d'intensité et c'est la dernière valeur comptabilisée par chaque compteur qui est transmise lors du transfert.

La détermination de l'indice de vieillissement s'effectue par calcul cyclique à partir des valeurs à sauvegarder et en fonction de formules bien connues en ce domaine, telles celles fournies par "le Guide de charges pour transformateurs immergées dans l'huile" établi par le CEI.

A titre d'exemple non limitatif on citera la relation de Montsinger extraite de ce guide, selon laquelle la vitesse relative de consommation de vie d'un transformateur à une température $\theta$ C1 comparée à celle à la température $\theta$ C2 est telle

$$V = e^{0,693 (\theta C1 - \theta C2)/6}$$

la valeur $\theta$ C1 étant de 98° C pour un transformateur fonctionnant à la puissance nominale et à température ambiante de 20° C avec un échauffement du point chaud de 78° C.

Comme indiqué plus haut la température du point chaud est calculée en tenant compte des valeurs de température et de charge sauvegardées qui permettent de déterminer cycliquement les pertes et l'indice de vieillissement.

Une classique intégration

$$\int_0^t V \, dt$$

permet de déterminer consommation en heures de vie du transformateur et par conséquent d'obtenir un indice de vieillissement du transformateur à partir de la température mesurée et de la durée totale de mise sous tension du transformateur.

Ce calcul s'effectue cycliquement et se traduit donc par un programme spécifique qui ne sera pas développé ici, dans le mesure où il est banal et n'a qu'un rapport indirect avec l'invention, les résultats se traduisent au niveau d'un compteur-décompteur dont la dernière valeur calculée est transmise lors du transfert de fin de période d'observation.

## Revendications

1. Dispositif de suivi pour transformateur (2) de distribution d'énergie électrique auquel sont ajoutés des organes de mesure (3), notamment d'intensité et de température, caractérisé en ce qu'il comporte un agencement (4), installé sur le site du transformateur suivi, qui comprend selon un arrangement connu un microprocesseur (5), associé à des mémoires (6, 7) et doté d'une horloge (8) interne ou externe, une alimentation secourue (40) pour le microprocesseur, l'horloge et les mémoires, deux interfaces de raccordement (9, 16) l'une aux organes de mesure du transformateur, l'autre à une unité de gestion extérieure (17), via éventuellement un équipement de saisie informatique portable (18), pour collecter les résultats fournis par les organes de mesure et pour les restituer à la demande, après traitement, et en ce que ledit agencement (4) comporte des moyens de suivi (60C) de température, comptabilisant les durées de fonctionnement du transformateur à l'intérieur de gammes prédéterminées de température de point chaud, à partir de relevés de température effectués par l'intermédiaire d'au moins un organe de mesure (3T) affecté au transformateur, des moyens de suivi (60B) de la charge du transformateur comptabilisant les durées de fonctionnement du transformateur à l'intérieur de gammes prédéterminées d'intensités, à partir de relevés effectués par l'intermédiaire d'au moins un organe de mesure d'intensité (3I) pour chaque phase secondaire du transformateur, des moyens de détermination des pertes du transformateur et de son vieillissement (60D) définissant respectivement lesdites pertes à partir des relevés de température et d'intensité effectués et au moins un indice de vieillissement pour le transformateur en fonction des indications comptabilisées par les divers moyens de suivi.

2. Dispositif de suivi selon la revendication 1, caractérisé en ce qu'il comporte de plus des moyens de suivi (69) des coupures comptabilisant la durée des coupures à l'intérieur de gammes prédéterminées de durée et leurs nombres à partir des indications d'absence de tension fournies par un circuit détecteur (12) connecté au secondaire du transformateur suivi.

3. Dispositif de suivi selon la revendications 2, caractérisé en ce que les moyens de suivi de température comportent des moyens de détermination d'une valeur à sauvegarder à partir d'un nombre prédéterminé de relevés successifs de mesures de températures conduisant à la détermination d'une valeur moyenne à partir de laquelle est déterminée, en liaison avec la charge du transformateur une valeur de point chaud qui constitue la valeur à sauvegarder, ainsi qu'au moins un compteur sommateur par gamme de température de manière à comptabiliser par addition les valeurs à sauvegarder.

4. Dispositif de suivi selon la revendication 3, caractérisé en ce que les moyens de détermination des pertes comportent au moins un compteur sommateur comptabilisant par addition les pertes successives respectivement déterminées à partir d'une valeur à sauvegarder de charge et de la valeur à sauvegarder de température correspondante de point chaud.

5. Dispositif de saisie selon la revendication 4, caractérisé en ce que les moyens de détermination de valeur à sauvegarder pour le suivi de charge (60B) déterminent cycliquement chaque valeur d'intensité à sauvegarder pour chacune des m phases secondaires du transformateur (2) par calcul d'une valeur finale obtenue en prenant la moyenne de n valeurs obtenues chacune en faisant la moyenne parmi p plus grande valeurs d'intensité successivement obtenues chacune en sélectionnant la plus grande valeur efficace d'intensité parmi r.s relevés d'intensité réalisés pour la phase considérée au cours de r cycles de relevés successifs comportant chacun une succession de s relevés par phase.

6. Dispositif de saisie selon la revendication 3, caractérisé en ce que les moyens de détermination de valeur à sauvegarder pour le suivi de température déterminent cycliquement chaque valeur de température à sauvegarder par calcul d'une valeur moyenne sur k relevés successifs répartis sur un temps choisi très supérieur à la durée d'un cycle de détermination de valeur à sauvegarder pour le suivi de charge.

## Claims

1. A monitoring device for monitoring an electrical power distribution transformer (2) having measuring instruments (3) added thereto, in particular for measuring current and temperature, the device being characterized in that it comprises an arrangement (4) installed on the site of the monitored transformer and comprising a conventional arrangement of a microprocessor (5) associated with memories (6, 7) and provided with an internal or external clock (8), and a backed-up power supply (40) for the microprocessor, for the clock, and for the memories, together with two connection interfaces (9, 16), one for connection to the transformer measuring instruments, and the other for connection to an external control unit (17), optionally via portable computer input equipment (18), for the purpose of collecting the results provided by the measuring instruments and for reproducing them on request after processing, and in that said arrangement (4) includes temperature monitoring means (16) for keeping account of transformer operating times within predetermined temperature ranges for its hot point, on the basis of temperature readings performed by at least one measuring instrument (3T) associated with the transformer, means (60B) for monitoring the load on the transformer, keeping account of transformer operating durations within predetermined current ranges on the basis of readings performed by at least one current measuring instrument (3I) for each secondary phase of the transformer, means for determining transformer losses, and means (60D) for determining transformer aging, said means respectively defining the losses on the basis of the temperature and current measurements taken, and at least one transformer aging index as a function of the information taken into account by the various monitoring means.

2. A monitoring device according to claim 1, characterized in that it further includes power cut monitoring means (69) for keeping account of power cut durations within predetermined duration ranges, and the number of power cuts, on the basis of tension-absent information provided by a detector circuit (12) connected to the secondary winding of the monitored transformer.

3. A monitoring device according to claim 2, characterized in that the temperature monitoring means include means for determining a value to be saved on the basis of a predetermined number of successive temperature measurement readings giving rise to a mean value being determined on the basis of which a hot point temperature value constituting the value to be saved is determined in connection with the load on the transformer, together with at least one totalizing counter per temperature range to keep account of the values to be saved by summing them.

4. A monitoring device according to claim 3, characterized in that the means for determining losses include at least one totalizing counter keeping account by summing successive losses respectively determined on the basis of a load value to be saved and on the basis of the corresponding value to be saved for the hot point temperature.

5. A monitoring device according to claim 4, characterized in that the means for determining the value to be saved for keeping account of the load (60B), cyclically determine each current value to be saved for each of $m$ secondary phases of the transformer (2) by calculating a final value obtained by taking the mean of $n$ values each obtained by taking the mean of $\overline{p}$ largest current values each successively obtained by selecting the largest rms current value from $r.s$ current readings taken for each phase under consideration over $r$ successive reading cycles each comprising a succession

of $\underline{s}$ readings per phase.

6. A monitoring device according to claim 3, characterized in that the means for determining the value to be saved for monitoring temperature cyclically determine each temperature value to be saved by calculating a mean value of $\underline{k}$ successive readings taken over a period of time selected to be much greater than the duration of one cycle for determining the value to be saved for monitoring load.

**Patentansprüche**

1. Überwachungseinrichtng für einen elektrischen Energieverteilungstransformator (2), an den Meßgeräte (3), insbesondere für die Messung der Stromstärke und der Temperatur, angeschlossen sind, dadurch gekennzeichnet, daß die Einrichtung eine am Aufstellungsort des überwachten Transformators installierte Schaltung (4) aufweist, die in bekannter Weise einen Mikroprozessor (5), der mit Speichern (6, 7) verbunden und mit einem inneren oder äußeren Taktgeber (8) ausgestattet ist, eine gesicherte Stromversorgung (40) für den Mikroprozessor, den Taktgeber und die Speicher und zwei Anschlußschnittstellen (9, 16) aufweist, wovon eine für die Meßgeräte des Transformators und die andere für eine äußere Verwaltungseinheit (17), eventuell unter Vorschaltung einer tragbaren Station (18) zur Erfassung von Informationsdaten, bestimmt ist, wobei die Einheit zur Sammlung der von den Meßgeräten gelieferten Resultate und zur Ausgabe derselben nach Verarbeitung und bei Bedarf dient, und daß die Schaltung (4) Temperaturüberwachungsmittel (60C), die auf der Basis von mit Hilfe mindestens eines dem Transformator zugeordneten Meßgeräts (3T) durchgeführten Temperaturablesungen die Betriebszeiten des Transformators innerhalb vorbestimmter Heißpunkt-Temperaturkategorien registrieren, Mittel (60B) zur Überwachung der Belastung des Transformators, die auf der Basis von mit Hilfe mindestens eines Strommeßgeräts (3I) für jede Sekundärphase des Transformators durchgeführten Ablesungen die Betriebszeiten des Transformators innerhalb vorbestimmter Stromstärkenkategorien registrieren, und Mittel (60D) zur Bestimmung der Verluste des Transformators und seiner Alterung aufweist, die die Verluste auf der Basis der durchgeführten Temperatur- und Stromstärkeablesungen sowie mindestens einen Alterungsindex für den Transformator in Abhängigkeit von den durch die verschiedenen Überwachungsmittel registrierten Angaben definieren.

2. Überwachungseinrichtung nach Anspruch 1, dadurch gekennzeichnet, daß sie weiter Mittel (69) zur Überwachung der Betriebsunterbrechungen aufweist, die die Dauer der Unterbrechungen innerhalb vorbestimmter Zeitdauerkategorien sowie ihre Anzahl aufgrund der Anzeigen über das Fehlen der Spannung registrieren, welche ein mit der Sekundärwicklung des überwachten Transformators verbundener Detektorkreis (12) liefert.

3. Überwachungseinrichtung nach Anspruch 2, dadurch gekennzeichnet, daß die Temperaturüberwachungsmittel Mittel zur Bestimmung eines abzusichernden Werts auf der Basis einer vorbestimmten Anzahl von aufeinanderfolgenden Ablesungen der Temperaturmessungen aufweisen, wobei diese Ablesungen zur Bestimmung eines Mittelwerts führen, aufgrund dessen in Verbindung mit der Belastung des Transformators ein Heißpunkttemperaturwert festgelegt wird, der den abzusichernden Wert bildet, und daß die Einrichtung mindestens einen Summenzähler pro Temperaturkategorie aufweist, so daß die abzusichernden Werte durch Addition registriert werden.

4. Überwachungseinrichtung nach Anspruch 3, dadurch gekennzeichnet, daß die Verlustbestimmungsmittel mindestens einen Summenzähler aufweisen, der die aufeinanderfolgenden Verluste durch Addieren registriert, wobei diese jeweils auf der Basis eines abzusichernden Belastungswerts und des entsprechenden abzusichernden Heißpunkttemperaturwerts bestimmt werden.

5. Überwachungseinrichtung nach Anspruch 4, dadurch gekennzeichnet, daß die Mittel (60B) zur Bestimmung des für die Belastungsüberwachung abzusichernden Werts zyklisch jeden abzusichernden Stromstärkewert in jeder der m Sekundärphasen des Transformators (2) durch Berechnung eines Endwerts bestimmen, der unter Verwendung des Mittelwerts aus n Werten erhalten wurde, wobei jeder von diesen durch Mittelwertbildung aus den in der betreffenden Phase erreichten p größten Stromstärkewerten erhalten wurde, die ihrerseits jeweils durch Auswahl des größten Effektivwerts der Stromstärke aus r.s für die betreffende Phase durchgeführten Stromstärkeablesungen gewonnen wurden, und zwar im Verlauf von r aufeinanderfolgenden Ablesezyklen, von denen jeder eine Folge s Ablesungen je Phase umfaßt.

6. Überwachungseinrichtung nach Anspruch 3, dadurch gekennzeichnet, daß die Mittel zur Bestimmung des für die Temperaturüberwachung abzusichernden Werts zyklisch jeden abzusichernden Temperaturwert durch Berechnung eines Mittelwerts aus k aufeinansderfolgenden Ablesungen bestimmen, wobei diese über eine Zeitdauer verteilt sind, die wesentlich größer als die Dauer eines Zyklus zur Bestimmung des für die Überwachung der Belastung abzusichernden Werts ist.

FIG.1

FIG.2A

FIG.2B

EP 0 199 256 B1

14

# FIG.3

56 — MISE SOUS TENSION

57 — AUTO - TEST

58 — INITIALISATIONS

59 — COUPURE DE TENSION

NON

OUI

60 — MESURE

61 — PRISE EN COMPTE DES COUPURES

62 — DEMANDE DE TRANSFERT

NON

OUI

63 — TRANSFERT

# FIG.4

58 INITIALISATION

59A PRESENCE TENSION SECONDAIRE

OUI — NON

59C FIN DE COUPURE

NON — OUI

68 RETOUR AU PROGRAMME DE MESURE

67 COMPTABILISATION DE LA COUPURE

59B COUPURE EN COURS

OUI — NON

64 INITIALISATION COMPTAGE

66 INCREMENTATION

65 TEMPORISATION

62 DEMANDE DE TRANSFERT

OUI — NON

EP 0 199 256 B1

16

# FIG.5

60A — INITIALISATION

60B — MESURE D'INTENSITE ET TRAITEMENT

60C — MESURE DES TEMPERATURES ET TRAITEMENT

60D — DETERMINATION DES FACTEURS DE SUIVI